# EUROPEAN PATENT APPLICATION

(11) **EP 1 944 324 A1**
(43) Date of publication of application: **16.07.2008**
(21) Application number: 06797833.8
(22) Date of filing: 12.09.2006
(51) Int. Cl.: C08F 2/44, C08F 2/38, C08F 2/46, G02B 5/20, G02F 1/1335, G03F 7/004, G03F 7/033, H01R 33/76

(54) **IC SOCKET SET**

(30) Priority: 13.10.2005 JP 2005299169
(71) Applicant: Tyco Electronics AMP K.K., Kawasaki-shi, Kanagawa 213-8535 (JP)
(72) Inventor: TODA, Shinsaku, Tyco Electronics AMP K.K., Kawasaki-shi, Kanagawa 2138535 (JP); INOUE, Masashi, Tyco Electronics AMP K.K., Kawasaki-shi, Kanagawa 2138535 (JP); YAMAMOTO, Yoshihisa, Tyco Electronics AMP K.K., Kawasaki-shi, Kanagawa 2138535 (JP)
(74) Representative: Johnstone, Douglas Ian
(86) International application number: PCT/JP2006/318026
(87) International publication number: WO 2007/043270

(57) **Abstract**

Provided is an IC socket set which ensures degrees of freedom in layout of an electric circuit board. The IC socket set (1) is provided with a package receiving unit (20), and a package fixing unit (30) combined with the package receiving unit. The package receiving unit (20) is provided with an insulating housing (21) and a contact (22). Since an opening (311) of the base material plate (31) fits in the insulating housing (21) even in a direction rotated 180 degrees, at the time of combining the package fixing unit (30) having an opening/closing member (33) with the package receiving unit (20), the direction of one side (312) whereupon the opening/closing member (33) is arranged can be selected among a plurality of directions, irrespective of the direction wherein the package receiving unit (20) is connected.

## Description

### Technical Field

The present invention relates to an IC (Integrated Circuit) socket set that is an assembly of units having an IC socket for supporting an IC package to connect a circuit on an electric circuit board and the IC package.

### Background Art

Conventionally, IC sockets are used for electrically connecting IC packages mounted with semiconductor elements to wiring on electric circuit boards. Here, the IC packages include those of a type called an LGA (Land Grid Array) in which planar electric contact points are disposed on its undersurface and a type called a BGA (Ball Grid Array) in which spherical electric contact points are disposed. An IC socket which supports these types of IC packages has an insulating housing in which contacts for connecting to an electric circuit board are disposed, and the insulating housing is soldered to the electric circuit board with a part of a base material plate inserted in it. A pressure cover which applies a load to the IC package is fitted to the base material plate, and a lever which opens and closes the pressure cover is fitted to one side of the base material plate to be tiltable (See Patent Document 1, for example).

In order to fit the IC package to the IC socket, the lever is pulled up first to open the pressure cover, and the IC package is set in the insulating housing. Next, the pressure cover is brought into the lowered state, and the lever is pushed down, whereby the pressure cover pushes down the IC package from above. Thereby, a normal load toward the contacts is applied to the IC package.
Patent Document 1: Japanese Patent Laid-Open No. 2005-108615

Incidentally, with sophistication in functionality and reduction in size of electronic equipment, electric circuit boards are mounted with IC packages with high density. For example, in a server type computer, a number of IC packages loaded with processors are mounted on the electric circuit boards with high density in order to enhance processing performance while achieving space saving. Here, the IC socket which supports the IC package requires a space for lever operation, and therefore, when the IC sockets are to be disposed with high density, the space for the lever operation interferes with other components or spaces for lever operation of the other IC sockets. As a result, the positions for the IC sockets are limited, and the degree of freedom in wiring on the electric circuit board is impaired.

In view of the above described circumstances, the present invention has an object to provide an IC socket set for constituting an IC socket capable of ensuring a degree of freedom in layout of an electric circuit board.

### Disclosure of the Invention

An IC socket set of the present invention that solves the above described object is an IC socket set which is an assembly of units constructing an IC socket for supporting an IC package with electric contact points disposed on an undersurface to connect a circuit on an electric circuit board and the IC package, the IC socket set includes:
a package receiving unit which receives the IC package, and connects the IC package and the circuit on the electric circuit board, and
a package fixing unit which is combined with the package receiving unit to fix the IC package to the package receiving unit,
wherein the package receiving unit includes:
an insulating housing having a frame part in which a recessed part housing the IC package and an outer peripheral wall surrounding in a frame form the recessed part are formed, and
contacts each of which is fixed to the insulating housing with one end in contact with the electric contact point on the undersurface of the IC package housed in the recessed part of the insulating housing and the other end connected to the circuit on the electric circuit board, and
the package fixing unit includes:
   a base material plate having an opening in which the frame part of the insulating housing is fitted even in any orientation of orientations with respect to the insulating housing,
   a load applying plate which is pivotally supported at the base material plate to be openable and closable, and applies a load to the IC package housed in the recessed part of the insulating housing when the load applying plate is in a closed state, and
   an opening and closing member which has a lever that is supported by the base material plate and disposed outside the base material plate along one side of the base material plate, opens and closes the load applying plate in accordance with an operation of the lever and is locked to the base material plate in a closed state to hold the load applying plate in the closed state.

According to the IC socket set of the present invention, the frame part of the insulating housing is fitted in the opening of the base material plate included in the package fixing unit in any orientation of plural orientations with respect to the insulating housing. Therefore, when the package fixing unit including the opening and closing member is combined with the package receiving unit, the orientation of the side of the base material plate in which the lever of the opening and closing member is placed is selectable from plural orientations. Accordingly, the degree of freedom in layout of the electric circuit board mounted with the IC socket can be ensured. In the case of manufacturing the IC socket, there is no need of manufacturing plural kinds of IC sockets differing in fitting orientation from one another.

Here, it is preferable that the frame part formed at the insulating housing has a contour shape of point symmetry, or the opening formed in the base material plate is formed into a shape of point symmetry.

Thereby, the package fixing unit including the base material plate can be also combined with the package receiving unit even in the orientation rotated 180 degrees with respect to the package receiving unit. Therefore, by the simple structure, the position of the lever can be adapted separately from the orientation in which the package receiving unit is mounted. Further, the position of the lever can be changed irrespective of the orientation in which the package receiving unit is mounted, and therefore, there is no need of manufacturing plural kinds of IC socket sets differing in fitting orientation from one another.

Further, the package receiving unit preferably includes a guide plate which is mounted on the outer peripheral wall of the frame part, is formed into a substantially frame shape smaller than the opening of the base material plate, and positions the IC package which is received by the package receiving unit.

By including the guide plate, positioning of the IC package and protection of the contacts can be performed more reliably. Since the guide plate is smaller than the opening of the base material plate, the package receiving unit already mounted with the guide plate is mounted on the electric circuit board, and after the reflow step, the package fixing unit can be combined. Specifically, in the mounting stage of the IC socket, the step of mounting the guide plate can be omitted.

Further, the package receiving unit preferably includes a plate-shaped suction member which is attachably and detachably placed on the insulating housing, and lifts up the package receiving unit by being sucked.

The suction member is placed on the insulating housing, and thereby, the package receiving unit is more easily carried by sucking it with a fitting machine. The suction member is provided attachably and detachably, and therefore, it is removed after the package receiving unit is mounted on the electric circuit board.

According to the IC socket set of the present invention, the degree of freedom in layout of the electric circuit board can be ensured.

### Brief Description of the Drawings

Fig. 1 is a perspective view showing an IC socket set which is an embodiment of the present invention.
Fig. 2 is a perspective view of the IC socket which is constructed by combining a package receiving unit and a package fixing unit shown in Fig. 1.
Fig. 3 is an exploded perspective view showing both of the package receiving unit and the package fixing unit shown in Fig. 1.
Fig. 4 is a sectional view showing a state in which contacts are fixed to an insulating housing shown in Fig. 3.
Fig. 5 is an opened-up view of the IC socket shown in Fig. 2 seen from a side of one side in which a lever is placed.
Fig. 6 is a plane view of the insulating housing, guide plate and base material plate shown in Fig. 3.
Fig. 7 is a plane view of a state in which the insulating housing, the guide plate and the base material plate shown in Fig. 6 are combined.
Fig. 8 is a perspective view showing a state of combining each of the package fixing units with the package receiving unit shown in Fig. 1.
Fig. 9 is a view showing a part of an interior of electronic equipment to which the IC socket shown in Fig. 2 is applied.

### Best Mode for Carrying Out the Invention

Hereinafter, an embodiment of the present invention will be described with reference to the drawings.

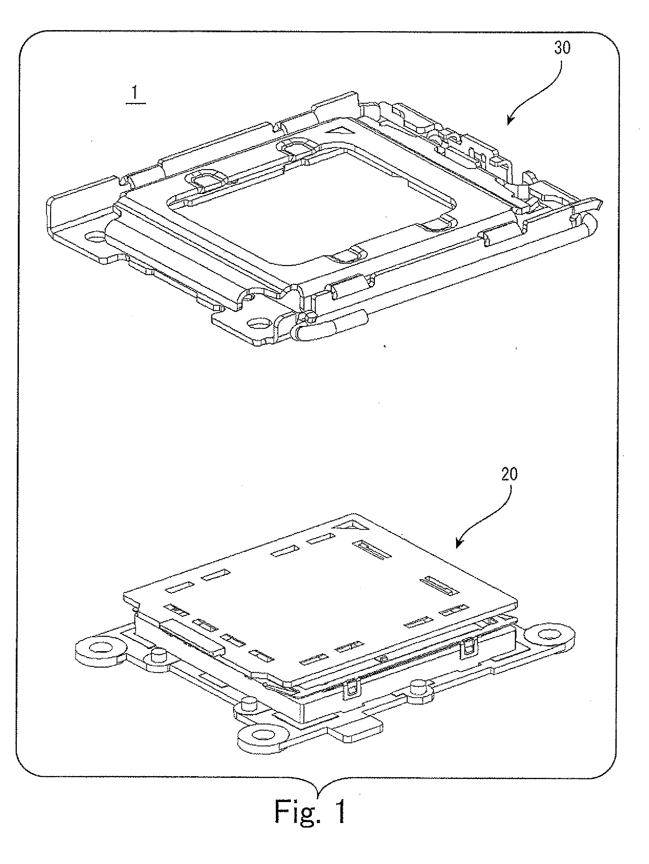

Fig. 1 is a perspective view of an IC socket set which is one embodiment of the present invention.

An IC socket set 1 shown in Fig. 1 is a unit assembly with a package receiving unit 20 and a package fixing unit 30 to be combined with the package receiving unit 20 as components. By combining the package fixing unit 30 with the package receiving unit 20, the IC socket is constructed. The package receiving unit 20 receives an IC package and connects the received IC package and the circuit on an electric circuit board. The package fixing unit 30 fixes the IC package to the package receiving unit.

The IC socket set 1 includes a mode in which the package receiving unit 20 and the package fixing unit 30 are separated by being housed in, for example, separate housing cases respectively, and also includes a mode in which the package fixing unit 30 is combined with the package receiving unit 20 to construct the IC socket. Hereinafter, one embodiment of the IC socket set of the present invention will be described based on an example of an IC socket 4 in a constructed state.

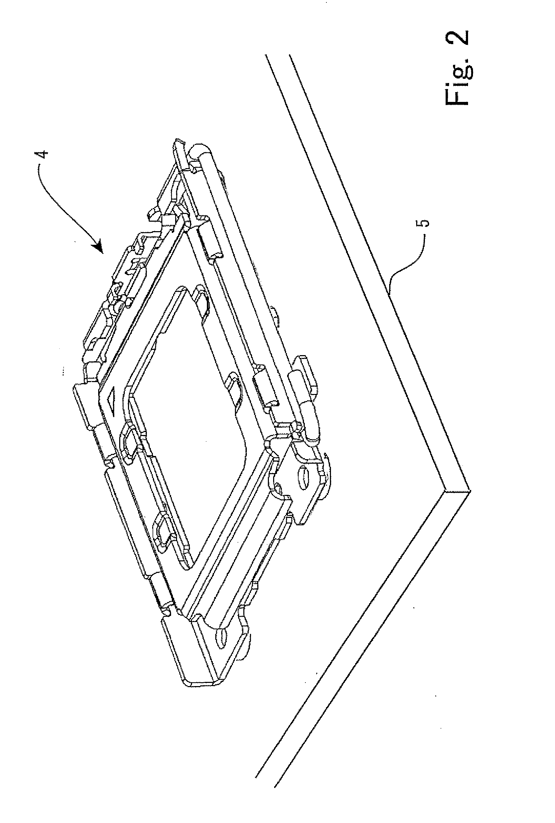

Fig. 2 is a perspective view of an IC socket which is constructed by combining the package receiving unit and the package fixing unit constituting the IC socket set shown in Fig. 1 on an electric circuit board. The IC socket 4 is a socket for receiving an IC package of a type called an LGA (Land Grid Array) in which plural plate-shaped electric contact points are disposed in a matrix form on its undersurface. The IC socket 4 is surface-mounted on an electric circuit board 5 which is placed on, for example, a server computer or the like and is loaded with a CPU (Central Processing Unit). The IC socket 4 mounted on the electric circuit board 5 supports an IC package not illustrated, and connects circuit wiring on the electric circuit board 5 and the IC package.

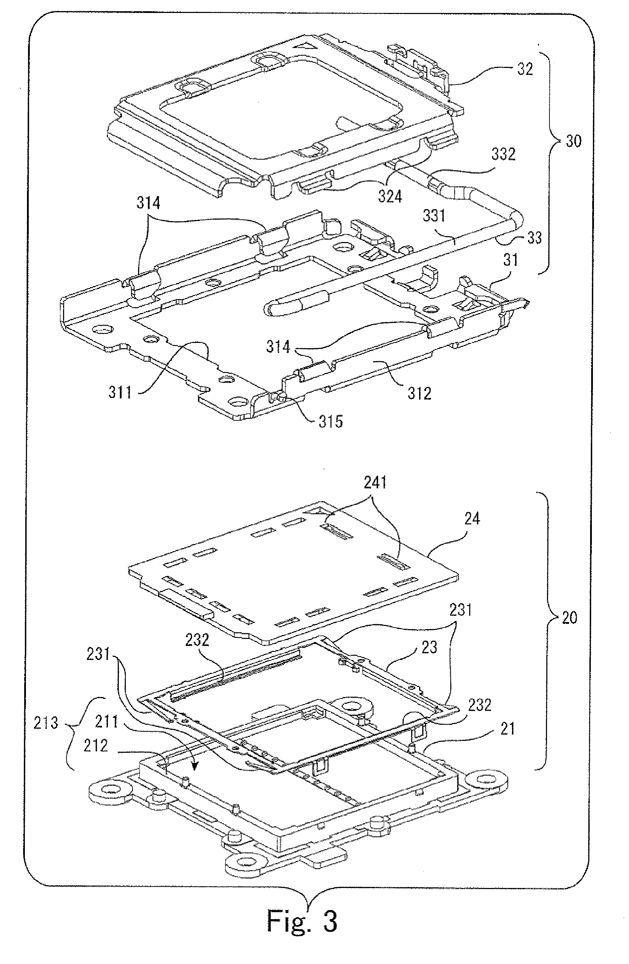

Fig. 3 is an exploded perspective view showing both the package receiving unit and the package fixing unit shown in Fig. 1.

The package receiving unit 20 includes an insulating housing 21, contacts 22, a guide plate 23 and a suction member 24.

The insulating housing 21 is made by forming a resin into a substantially rectangular shape, and has a frame part 213. In the frame part 213, a recessed part 211 which houses an IC package and an outer peripheral wall 212 which surrounds the recessed part 211 in a frame form are formed. Contacts that will be described hereinafter are fixed to the insulating housing 21. For convenience, illustration of very small contacts 22 is omitted.

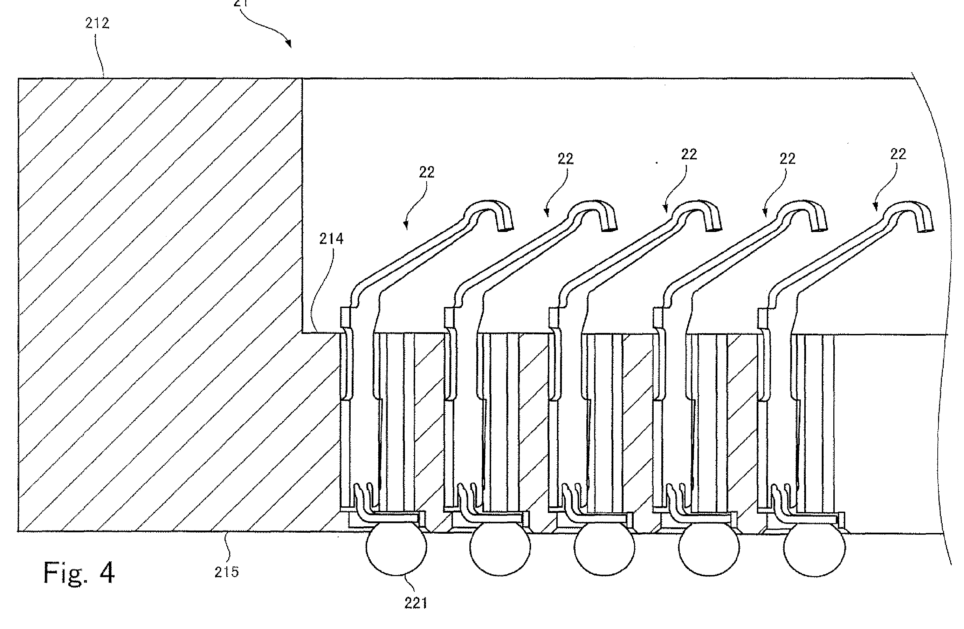

Fig. 4 is a sectional view showing a state in which the contacts are fixed to the insulating housing shown in Fig. 3.

The contacts 22 are arranged and fixed to a bottom part 214 of the recessed part 211 surrounded by the outer peripheral wall 212 of the insulating housing 21. One end of the upper side of the contact 22 is in contact with the electric contact point on the undersurface of the IC package. Meanwhile, at the other end, that is, one end at the lower side of the contact 22, a solder ball 221 is formed to project from a bottom 215 of the insulating housing 21. The insulating housing 21 shown in the drawing is mounted on the electric circuit board, and the solder ball 221 is heated in contact with the wiring, whereby, the solder ball 221 is melted, and the one end at the lower side of the contact 22 is connected to the circuit wiring on the electric circuit board.

Description will be made by returning to Fig. 3. The guide plate 23 included in the package receiving unit 20 is formed by punching and bending a metal plate, and is formed into a substantially frame shape. The guide plate 23 includes four spring parts 231 which extend diagonally downward from four corners of the substantially frame shape, and a holding part 232 which extends inside the frame from two sides of the substantially frame shape and holds the IC package. The four spring parts 231 of the guide plate 23 are placed on the outer peripheral wall 212 of the frame part 213, whereby, the guide plate 23 is disposed on the outer peripheral wall 212 in the raised state. The guide plate 23 positions the IC package which is received by the package receiving unit 20, and protects the contacts 22 at the time of fitting the IC package. Here, the guide plate 23 is formed to be smaller than an opening of a base material plate 31 that will be described later.

The suction member 24 is a member made by forming a resin into a substantially rectangular plate shape, and has claw parts 241 projected from the surface of the plate shape. The claw parts 241 are locked to the insulating housing 21, whereby the suction member 24 is attachably and detachably fitted onto the insulating housing 21 with the guide plate 23 therebetween. The suction member 24 is sucked by a fitting machine or the like in the state in which the suction member 24 is fitted to the insulating housing 21, and thereby, the package receiving unit 20 is lifted up and mounted on a board.

The package fixing unit 30 includes a base material plate 31, a load applying plate 32 and an opening and closing member 33.

The base material plate 31 is formed by punching and bending a metal plate, and an opening 311 for fitting the frame part 213 of the insulating housing 21, guide claws 314, and a locking part 315 which locks a lever of the opening and closing member 33 are formed.

The load applying plate 32 is formed by punching and bending a metal plate. The load applying plate 32 is pivotally supported by the base material plate 31 to be openable and closable. At the load applying plate 32, slide claws 324 which slide with respect to the guide claws 314 are formed. In the IC socket 4 which is constructed by combining the package fixing unit 30 with the package receiving unit 20, when the load applying plate 32 is brought into a closed state with the IC package housed in the recessed part 211 of the insulating housing 21, the load applying plate 32 applies a normal load to the IC package.

The opening and closing member 33 is formed by bending a metal wire rod, and has a lever 331 and a crankshaft part 332. The lever 331 is placed at the outer side of the base material plate 31 along one side 312 of the base material plate 31. The opening and closing member 33 is mounted so as to support the load applying plate 32 pivotally at the base material plate 31 with the crankshaft part 332. Thereby, the lever 331 of the opening and closing member 33 is supported at the load applying plate 32 by the crankshaft part 332. The opening and closing member 33 opens and closes the load applying plate 32 in response to the operation of the lever 331. The lever 331 is locked to the locking part 315 in the closed state, and thereby, the load applying plate 32 is held in the closed state. When an LGA type of IC package is fitted in the constructed IC socket 4 shown in Fig. 2, the lever 331 of the opening and closing member 33 is pulled up first to open the load applying plate 32, and the IC package is set in the recessed part 211 of the insulating housing 21. Next, the load applying plate 32 is brought into the lowered state, and the lever 331 is pushed down. The lever 331 is locked with the locking part 315, and thereby, the lever 331 stays in the position in which it is pushed down.

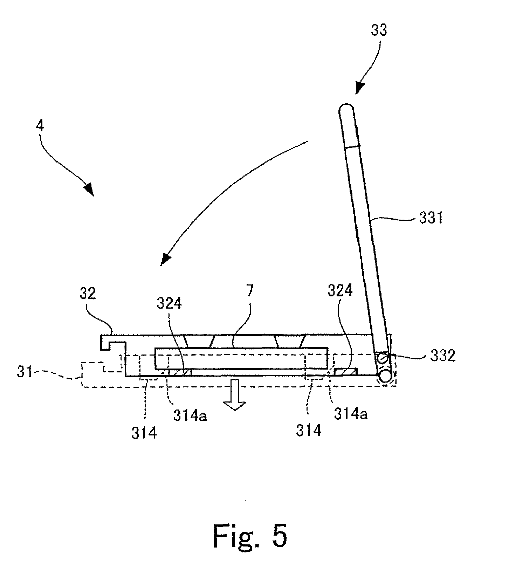

Fig. 5 is an opened-up view of the IC socket shown in Fig. 2 seen from the one side at which the lever is placed. The base material plate 31 is shown by the broken line, for the sake of convenience.

Fig. 5 shows the IC socket 4 in the state in which the lever 331 of the opening and closing member 33 is raised and a normal load is not applied to the IC package 7. At this time, the IC package 7 is mounted on the holding part 232 (Fig. 3) of the guide plate 23 which is lifted up on the outer peripheral wall 212 of the insulating housing 21, and the IC package 7 is not in contact with the contact 22. Therefore, the contact 22 is protected.

As the lever 331 is operated to tilt in such a manner that the lever 331 is pushed down in the arrow direction, the load applying plate 32 which is pivotally supported at the crankshaft part 332 of the opening and closing member 33 moves in the leftward direction in the drawing. At this time, the slide claws 324 formed at the load applying plate 32 slide on cam surfaces 314a of the guide claws 314 formed at the base material plate 31, and thereby, the load applying plate 32 pushes down the IC package 7 from above. Thereby, the IC package 7 sinks downward together with the guide plate 23 mounted with the IC package 7, and the electric contact points of the IC package 7 are pressed against each one end at the upper sides of the contacts 22 to be in contact with them. The lever 331 is locked to the outer side of the base material plate 31 along the one side 312 (see Fig. 3) of the base material plate 31 with the locking part 315, and thereby, the load applying plate 32 is kept in the closed state. At this time, the load applying plate 32 applies the normal load to the IC package 7.

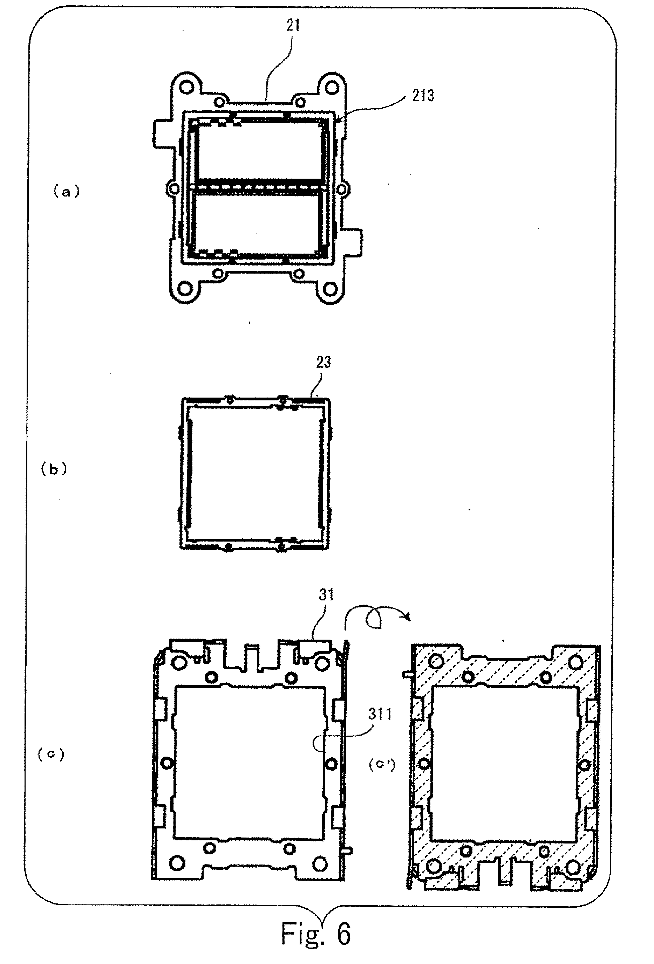

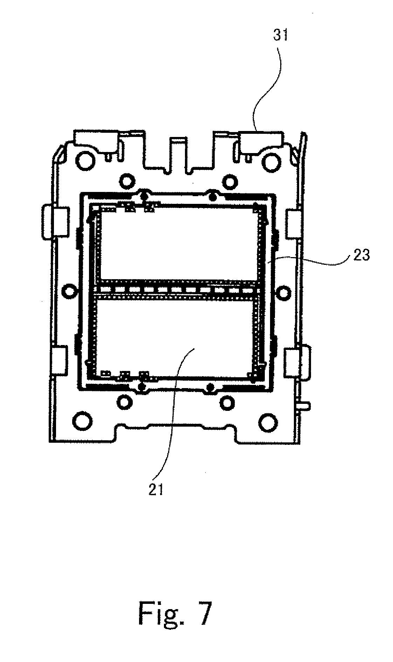

Fig. 6 is a plane view showing the insulating housing, the guide plate and the base material plate shown in Fig. 3. Fig. 7 is a plane view showing the state in which the insulating housing, the guide plate and the base material plate shown in Fig. 6 are combined.

Part (a) of Fig. 6 shows the insulating housing 21, part (b) shows the guide plate 23, and part (c) shows the base material plate 31. Part (c') shows the state in which the base material plate 31 shown in part (c) is rotated 180°.

The frame part 213 of the insulating housing 21 has a contour shape of point symmetry with respect to the center of the frame part 213. Specifically, the contour shape of the frame part 213 is the same as the contour shape when the insulating housing 21 is rotated 180 degrees along the rotational axis passing through the center of the frame part 213 and extending in the direction to be fitted in the opening 311 of the base material plate 31.

Further, the opening 311 of the base material plate 31 shown in part (c) of Fig. 6 is formed into a shape of point symmetry with respect to the center of the opening 311. Specifically, the shape of the opening 311 is the same as the shape (c') of the opening 311 in the orientation in which the base material plate 31 is rotated 180 degrees along the rotational axis passing through the center of the opening 311 and extending in the direction in which the frame part 213 of the insulating housing 21 is fitted in.

Further, as shown in part (b) of Fig. 6, the contour shape of the guide plate 23 is formed to be smaller than the opening 311 of the base material plate 31, and the contour shape of the guide plate 23 is further formed into the shape of point symmetry with respect to the center of the contour of the guide plate 23.

When the IC socket 4 is constructed by combining the package receiving unit 20 and the package fixing unit 30, the frame part of the insulating housing 21 mounted with the guide plate 23 is fitted in the opening 311 of the base material plate 31 (see Fig. 7). At this time, the insulating housing 21, the guide plate 23 and the base material plate 31 are combined in the postures shown in parts (a), (b) and (c) of Fig. 6 respectively.

Here, the contour shapes of the frame part 213 of the insulating housing 21 and the guide plate 23 are formed into the shapes of point symmetry, and the opening 311 of the base material plate 31 is formed into the shape of point symmetry. Therefore, the frame part 213 is also fitted in even when the base material plate 31 is in the orientation rotated 180 degrees. Specifically, the insulating housing 21 and the guide plate 23 are respectively in the postures shown in parts (a) and (b) of Fig. 6, and the base material plate 31 can be combined with them in the posture shown in part (c') which is rotated 180 degrees with respect to the posture shown in part (c) of Fig. 6.

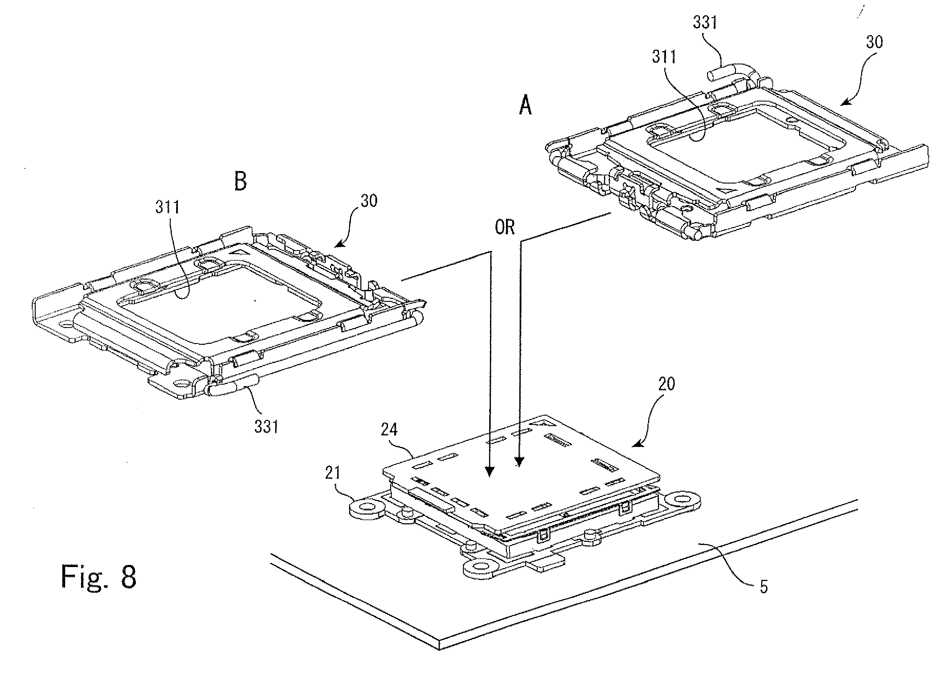

Fig. 8 is a perspective view showing the state in which the package fixing unit is combined with the package receiving unit shown in Fig. 1.

According to the IC socket set 1 of this embodiment, the frame part 213 is fitted in the opening 311 of the base material plate 31 even when the opening 311 is in the orientation rotated 180 degrees with respect to the insulating housing 21. Therefore, when the package fixing unit 30 including the lever 331 is combined with the package receiving unit 20, the orientation of the one side 312 at which the lever 331 is placed can be selected in accordance with the space limitation irrespective of the orientation in which the package receiving unit 20 is mounted. For example, as shown in Fig. 8, the package fixing unit 30 can be combined with the package receiving unit 20 in the orientation shown in part A, or the orientation shown in part B in which the orientation shown in part A is rotated 180 degrees. Therefore, according to the IC socket set 1, the degree of freedom in layout of the electronic circuit board can be ensured. In the case of manufacturing the IC socket, there is no need to manufacture plural kinds of IC sockets differing in the fixing direction from each other.

Here, the process of mounting the package receiving unit and the package fixing unit of the IC socket set on an electric circuit board and constructing them as the IC socket will be described.

First, the package receiving unit 20 is lifted up by the plate-shaped suction member 24 being sucked by an automatic fitting machine or the like, and mounted in a predetermined position of the electric circuit board 5 on which wiring is formed. At this time, the solder balls 221 (see Fig. 4) formed on the bottom of the insulating housing 21 are in contact with the wiring formed on the electric circuit board 5. Next, the package receiving unit 20 is sent to a reflow step together with the electric circuit board 5. The solder balls 221 are melted in the reflow step, and thereby, the wiring and each one end of the contacts are connected. After the reflow step, the package fixing unit 30 shown in Fig. 8 is combined with the package receiving unit 20 so that the opening 311 of the base material plate 31 is fitted in the frame part 213 of the insulating housing 21. Here, the package fixing unit 30 can be combined with the package receiving unit 20 in either direction shown in part A or B. Thereafter, the base material plate 31 is firmly fixed to the electric circuit board 5 by being screwed onto the electric circuit board 5.

The IC socket set 1 of this embodiment has the constitution including the package receiving unit 20 and the package fixing unit 30 which is combined with the package receiving unit, in which the package receiving unit 20 includes the insulating housing 21 and the contacts 22. Therefore, when mounting on the electric circuit board 5, only the package receiving unit 20 is mounted in a predetermined position of the electric circuit board 5 first, and can be sent to the reflow step. After the reflow step, the package fixing unit 30 is combined with the package receiving unit 20 connected to the electric circuit board 5, and thereby the IC socket 4 can be constructed.

It is difficult to lift up the conventional IC socket by sucking it with a fitting machine since the base material plate and the load applying plate are integrally mounted to the insulating housing and the IC socket has heavy weight. As a result, there arises the need of additionally providing a special attachment exclusively for the IC socket in the fitting machine, or mounting the IC socket manually apart from automatic fitting of the other electronic components with a fitting machine in the step of mounting the electronic components on the electric circuit board.

According to the IC socket set 1 of this embodiment, the package receiving unit 20 which is mounted on the electric circuit board 5 does not have the base material plate 31 and the load applying plate 32, and is light, and therefore, it can be easily carried by being sucked with a fitting machine similarly to the other electronic components.

Further, the suction member 24 is placed on the insulating housing 21, and thereby, it becomes easier to carry the package receiving unit 20 by sucking it with a fitting machine. Since the suction member 24 is attachably and detachably placed, it is removed after the package receiving unit 20 is mounted on the electric circuit board 5.

Further, since the guide plate 23 is smaller than the opening 311 of the base material plate 31, the package receiving unit 20 already attached with the guide plate 23 is mounted on the electric circuit board 5, and the package fixing unit 30 can be combined with it after the reflow step, in the stage of constructing the IC socket 4. Therefore, in the stage of constructing the IC socket 4, the step of attaching the guide plate can be omitted.

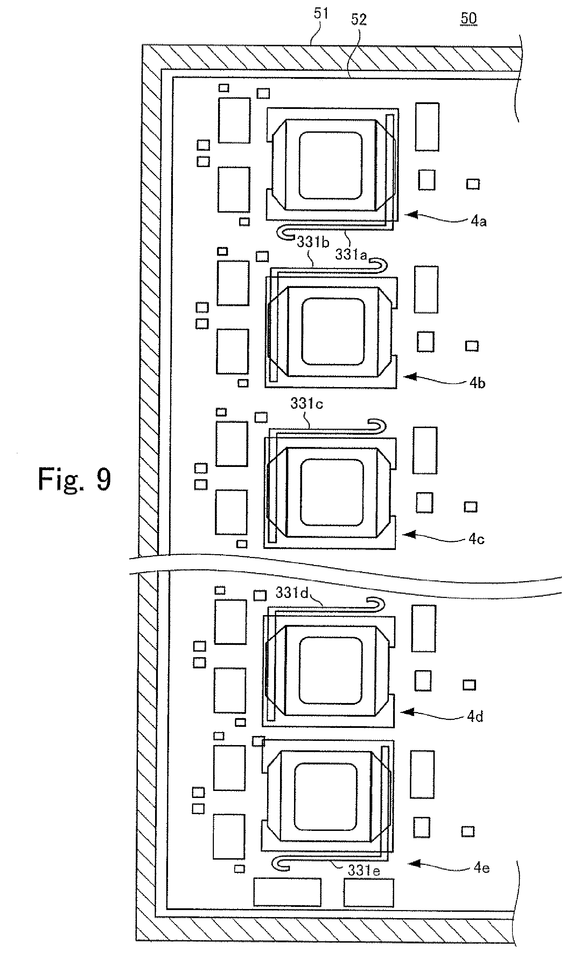

Fig. 9 is a view showing a part of the interior of the electronic equipment to which the IC socket shown in Fig. 2 is applied.

Fig. 9 shows an interior of a server computer 50 as an example of the electronic equipment. The server computer 50 adopts a multiprocessor method, and IC sockets 4a, 4b, 4c, 4d and 4e for mounting a number of CPUs are mounted on an electric circuit board 52 together with other electronic components. In the server computer 50, each of the CPUs has a substantially equivalent circuit configuration, and similar wiring layout is adopted in the periphery of each of the IC sockets 4a to 4e. Here, in the IC socket 4a among the IC sockets shown in Fig. 9, a lever 331a cannot be disposed in the orientation as in the other IC sockets 4b to 4d due to space limitation inside a casing 51 of the server computer 50. Further, the IC socket 4e needs to be disposed closely to the side of the IC socket 4d with the orientation of a lever 331e reversed from the IC sockets 4b to 4d since the other electronic components are disposed near the IC socket 4e.

In such cases, according to the conventional IC socket, the IC socket is disposed in the rotated orientation. However, if the IC socket is rotated, the orientation of the IC package is rotated. Therefore, the wiring layout needs to be changed correspondingly. As a result, the degree of freedom in the wiring layout is impaired.

According to the IC socket set 1 of this embodiment, with respect to the IC sockets 4a and 4e, only the package fixing unit 30 including the lever 331 is rotated 180 degrees with respect to the other IC sockets 4b to 4d, and can be combined with the package receiving unit 20, and therefore, the positions of the levers 331a and 331e can be changed while the orientation of the IC socket, and the wiring layout of the other peripheral electronic components are kept similarly to the other IC sockets 4b to 4d. Like this, according to the IC socket set 1, the degree of freedom in the layout of the electric circuit board is ensured. As a result, the IC socket can be disposed with high density while avoiding interference of the levers 331, and the degree of freedom in the wiring can be ensured.

One embodiment of the present invention is described above, but the present invention is not limited to the embodiment. For example, in this embodiment, the description is made such that the frame part 213 of the insulating housing 21 has the contour shape of point symmetry, and the opening 311 of the base material plate 31 is formed into the shape of point symmetry, but the present invention is not limited to this, and the IC socket set may adopt either the constitution in which the frame part 213 has a contour shape of point symmetry, or the constitution in which the opening 311 is formed into a shape of point symmetry.

Further, in this embodiment, the opening 311 of the base material plate 31 is described as being in the shape which is fitted in the frame part 213 even when it is in the orientation rotated 180 degrees with respect to the insulating housing 21, but the present invention is not limited to this, and the angle of rotation may be another angle. For example, the opening 311 may be in the shape which is fitted at every orientation rotated 90 degrees.

Further, in this embodiment, the IC socket 4 is described as a socket for an LGA type of IC package, but the present invention is not limited to this, and may be a socket for another type of IC package as long as it is an IC package with electric contact points being disposed on the undersurface.

## Claims

1. An IC socket set which is an assembly of units constructing an IC socket for supporting an IC package with electric contact points disposed on an undersurface to connect a circuit on an electric circuit board and the IC package, comprising:
a package receiving unit which receives the IC package, and connects the IC package and the circuit on the electric circuit board; and
a package fixing unit which is combined with the package receiving unit to fix the IC package to the package receiving unit,
wherein the package receiving unit comprises:
an insulating housing having a frame part in which a recessed part housing the IC package and an outer peripheral wall surrounding in a frame form the recessed part are formed; and
contacts each of which is fixed to the insulating housing with one end in contact with the electric contact point on the undersurface of the IC package housed in the recessed part of the insulating housing and the other end connected to the circuit on the electric circuit board, and
the package fixing unit comprises:
a base material plate having an opening in which the frame part of the insulating housing is fitted even in any orientation of a plurality of orientations with respect to the insulating housing;
a load applying plate which is pivotally supported at the base material plate to be openable and closable, and applies a load to the IC package housed in the recessed part of the insulating housing when the load applying plate is in a closed state; and
an opening and closing member which has a lever that is supported by the base material plate and disposed outside the base material plate along one side of the base material plate, opens and closes the load applying plate in accordance with an operation of the lever and is locked to the base material plate in a closed state to hold the load applying plate in the closed state.

2. The IC socket set according to claim 1, wherein the frame part formed at the insulating housing has a contour shape of point symmetry.

3. The IC socket set according to claim 1, wherein the opening formed in the base material plate is formed into a shape of point symmetry.

4. The IC socket set according to claim 1, wherein the package receiving unit includes a guide plate which is mounted on the outer peripheral wall of the frame part, is formed into a substantially frame shape smaller than the opening of the base material plate, and positions the IC package which is received by the package receiving unit.

5. The IC socket set according to claim 1, wherein the package receiving unit includes a plate-shaped suction member which is attachably and detachably placed on the insulating housing, and causes the package receiving unit to be lifted by being sucked.
